# EUROPÄISCHE PATENTSCHRIFT

(11) **EP 1 130 408 B1**
(45) Veröffentlichungstag und Bekanntmachung des Hinweises auf die Patenterteilung: **27.06.2007**
(21) Anmeldenummer: 01101831.4
(22) Anmeldetag: 26.01.2001
(51) Int. Cl.: G01R 31/317, H01L 21/66

(54) **Verfahren und Vorrichtung zur Anpassung/Abstimmung von Signallaufzeiten auf Leitungssystemen oder Netzen zwischen integrierten Schaltungen**
Method and apparatus for adaptation/adjustment of the delay time of signal between integrated circuits in networks or line systems
Méthode et dispositif d'adaptation/réglage de temps de propagation de signaux entre circuits intégrés dans des réseaux ou des systèmes de lignes de connexion

(30) Priorität: 03.02.2000 DE 10004649
(43) Veröffentlichungstag der Anmeldung: 05.09.2001
(73) Patentinhaber: Qimonda AG, 81739 München (DE)
(72) Erfinder: Muff, Simon, 85635 Höhenkirchen (DE)
(74) Vertreter: Müller - Hoffmann & Partner

(56) Entgegenhaltungen:
- WO-A-98/12706
- DE-A1- 3 301 673
- DE-A1- 19 825 607
- US-E- R E36 087

## Beschreibung

Verfahren und Vorrichtung zur Anpassung/Abstimmung von Signallaufzeiten auf Leitungssystemen oder Netzen zwischen integrierten Schaltungen

Die Erfindung betrifft ein Verfahren und eine Vorrichtung zur Anpassung/Abstimmung von Signallaufzeiten auf Leitungssystemen oder Netzen zwischen auf gedruckten Leiterplatten montierten integrierten Schaltungen, insbesondere schnellen Speicherbausteinen sowie eine damit hergestellte Speicherbaugruppe.

Bei schnellen Speicherbausteinen, sogenannten High Performance DRAMs, müssen die Signallaufzeiten verschiedener Netze bzw. Signalübertragungsleitungen auf Modul- bzw. Systemebene innerhalb weniger Picosekunden aufeinander abgestimmt sein, um die gewünschte Schnelligkeit und Leistungsfähigkeit des Speicherbausteins zu gewährleisten.

Solche Laufzeitdifferenzen werden hauptsächlich durch den kapazitiven Anteil der Einzelgehäuse, mit denen eine Speicherbaugruppe bestückt wird, beeinflusst. Durch herstellungstechnische Prozessgrenzen können die Einzelkomponenten aber nur innerhalb einer Größenordnung von ca. 20 fF aufeinander und auf die Leiterplatte abgestimmt werden. Dies reicht für ein maximales Verzögerungszeitfenster von etwa 20 ps aus. Die Feinabstimmung muss nach entsprechender Messung auf dem Applikationschip durchgeführt werden. Dabei ist zumeist eine Wiederholung dieses Mess- und Abstimmschritts erforderlich. Sind kleinere Verzögerungszeitfenster und eine feinere Abstimmung nötig, so wird bis heute auf teuere Basismaterialien, wie z. B. Keramik und/oder C4-Montage zurückgegriffen.

Die US Patentschrift Re. 36 087 offenbart das Abtrennen von fehlerhaften Kondensatoren auf einem Chip.

Es ist Aufgabe der Erfindung, ein kostengünstiges, einfaches und flexibles Verfahren, eine Vorrichtung zur Durchführung des Verfahrens sowie eine mit dem erfindungsgemäßen Verfahren herstellbare Speicherbaugruppe anzugeben, wobei kleinere Verzögerungszeitfenster als 20 ps auf gedruckten Leiterplatte aus herkömmlichem FR-4 Material bei der Applikation beliebiger Chips ohne kapazitive Feinabstimmung nach der Montage und einem Vermessen der Verzögerungszeit auf der Baugruppe realisiert werden können.

Die obige Aufgabe wird bei einem gattungsgemäßen Verfahren gelöst durch folgende Schritte
A) Vorsehen von Leiterplatten mit kapazitiven Laststrukturen an wenigstens einem Leiterbahnzug des Leitungssystems oder Netzes in der Nähe des oder der Gehäuse der integrierten Schaltung(en);
B) Messen aller relevanten Verzögerungs- bzw. Signallaufzeiten auf dem Netz oder dem Leitungssystem zwischen den integrierten Schaltungen;
C) selektives Abtrennen von bestimmten kapazitiven Laststrukturen von dem wenigstens einen Leiterbahnzug gemäß dem Messergebnis in Schritt B, um auftretende maximale Signalverzögerungen zu minimieren.

Die Schritte B) und C) können auch wiederholt ausgeführt werden. Die auf der Leiterplatte an wenigstens einer der Leitungen des Netzes in der Nähe des oder der Gehäuse der integrierten Schaltung oder der Schaltungen vorgesehenen kapazitiven Laststrukturen können eine Kapazität im Subfemtofaradbereich aufweisen, so dass auch kleinste Verzögerungszeitfenster unter 5 ps auf herkömmlichem FR-4 Material erreichbar sind.

Vorzugsweise wird der selektive Trennschritt zur Abtrennung bestimmter kapazitiver Laststrukturen durch Laserschneiden ausgeführt. Somit können bei dem erfindungsgemäßen Verfahren einzelne der in der Nähe der Gehäuse-Footprintfläche vorgesehenen kapazitiven Laststrukturen nach Vermessung der Verzögerungszeiten der einzelnen Leitungszüge, die zu dem Netz gehören, durch Laserschneiden selektiv von den Leitungszügen abgetrennt und somit die maximal auftretende Laufzeitverzögerungen minimiert werden.

Die Verbindungen der kapazitiven Laststrukturen zu den eigentlichen Signalübertragungsleitungen der Netze dürfen hierbei nicht mit Lötstopplack verdeckt sein, damit das Laserschneiden, welches in der Leiterplattenproduktion Stand der Technik ist ermöglicht wird.

Das erfindungsgemäße Verfahren lässt sich zur Anpassung von Signallaufzeiten auf Leitungssystemen oder Netzen zwischen auf gedruckten Leiterplatten montierten schnellen DRAM-Speicherbausteinen ohne vorherige Abstimmung derselben, bei unterschiedlich abgestimmten Chips und Gehäusen, bei unterschiedlichen Materialien von mehreren DRAM-Bausteinen auf einer gedruckten Leiterplatte sowie auch zum Ausgleich von Herstellungstoleranzen von gedruckten Leiterplatten und/oder Chipgehäusen einsetzen. Da die Feinabstimmung erfindungsgemäß nach der Leiterplattenbestückung möglich ist, können Teile, deren entsprechende Laufzeitdaten aus einem Spezifikationsbereich herausfallen, nachträglich einer Reparatur unterzogen werden und müssen nicht verworfen werden. Dies ermöglicht eine Steigerung der Ausbeute bei kleinem Verzögerungszeitfenster.

Außerdem lassen sich die schwer beeinflussbaren Herstellungstoleranzen der gedruckten Leiterplatten und der Chipgehäuse ausgleichen.

Eine zur Durchführung des erfindungsgemäßen Verfahrens geeignete Vorrichtung ist dadurch gekennzeichnet, dass sie in Kombination aufweist
- Haltemittel zur Halterung wenigstens einer mit der bzw. den integrierten Schaltung(en) bestückten Leiterplatte, die mit kapazitiven Laststrukturen an wenigstens einem Leiterbahnzug eines Leitungssystems oder Netzes in der Nähe des oder der Gehäuse der integrierten Schaltung(en) versehen ist bzw. sind;
- Messmittel zur Messung relevanter Verzögerungs- bzw. Signallaufzeiten auf den Netzen oder Leitungssystemen zwischen den integrierten Schaltungen auf der bzw. den Leiterplatte(n), und
- Trennmittel zur selektiven Abtrennung bestimmter kapazitiver Laststrukturen so, dass durch die Messmittel gemessene maximale Signalverzögerungen minimiert werden.

Eine mit dem oben geschilderten erfindungsgemäßen Verfahren herstellbare Speicherbaugruppe ist dadurch gekennzeichnet, dass die gedruckte Leiterplatte an wenigstens einer zu einem Signalübertragungsnetz oder -leitungssystem, das Signale zum/vom Speicherbaustein überträgt gehörenden Leiterbahn in der Nähe der Gehäuse-Footprintfläche des Speicherbausteins mit abtrennbaren Leitungsstrukturen wie Flächen oder Vias versehen ist, die zur Leiterbahn und zu dem Gehäuse des montierten Speicherbausteins eine kapazitive Last bilden, wobei bestimmte der kapazitiven Laststrukturen an Leiterbahnen mit maximaler Signalverzögerung zur Minimierung gemessener maximaler Signallaufzeiten selektiv abtrennbar sind.

Nachfolgend wird die Erfindung anhand der Zeichnungen näher erläutert. Es zeigen:
- Figur 1A und 1B: jeweils in Draufsicht eine Speicherbau gruppe und in vergrößerter Ansicht eine Ausschnittdar stellung derselben, die die erfindungsgemäßen kapaziti ven Laststrukturen zeigt und
- Figuren 2A, 2B und 2C: schematisch eine zur Durchführung des erfindungsgemäßen Verfahrens eingerichtete Vorrichtung jeweils beim Messschritt und beim selektiven Abtrennen bestimmter kapazitiver Strukturen.

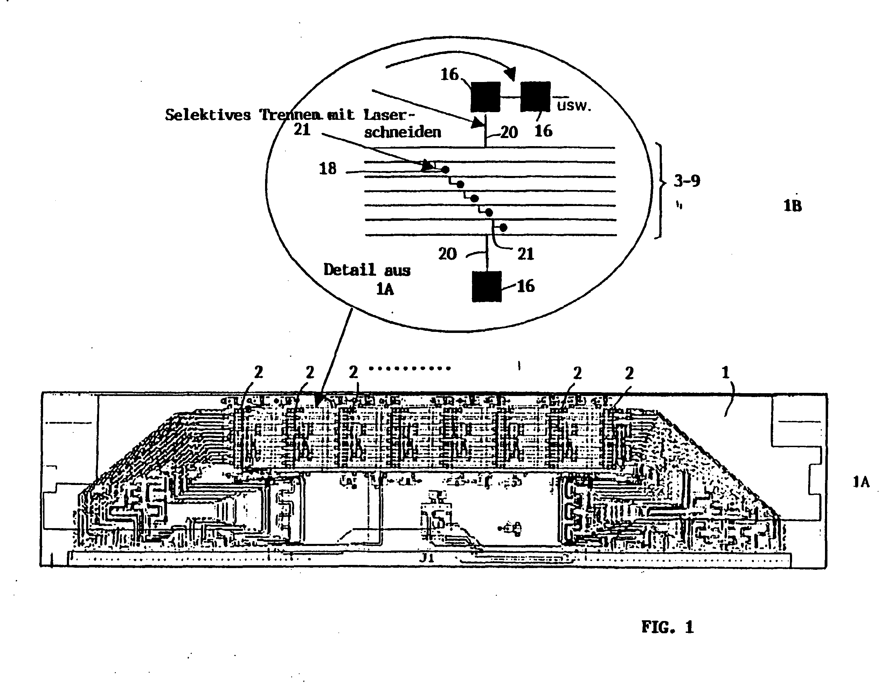

In Figur 1A ist in Draufsicht eine gedruckte Leiterplatte 1 dargestellt, die mit Speicherbausteinen 2 (z. B. acht) bestückt ist. Die Leiterplatte 1 kann aus üblichem FR-4 Material bestehen.

Gemäß Figur 1B weisen Leiterbahnzüge 3-9, die zu einem die Speicherbausteine 2 verbindenden Netz, z. B. einem Daten- oder Adressenbus gehören, kapazitive Laststrukturen in Form gedruckter Leiterflächen 16, die untereinander und mit einer jeweiligen Leiterbahn 3-9 durch dünne gedruckte Verbindungsleitungen 20 verbunden sind. In ähnlicher Weise können kapazitive Laststrukturen in Form von Durchkontaktierungen oder Vias 18 vorgesehen sein, die ebenfalls einzeln durch dünne aufgedruckte Verbindungsleitungen 21 mit jeweiligen Leiterbahnzügen 3-9 verbunden sind.

Erfindungsgemäß können nun nach der Messung der relevanten Verzögerungs- bzw. Signallaufzeiten auf den Netzen oder Leitungen zwischen den auf der gedruckten Leiterplatte 1 montierten Speicherbausteinen 2 selektiv bestimmte kapazitive Laststrukturen, d. h. einzelne Leiterflächen 16 und/oder Vias 18 abgetrennt werden, um auftretende maximale Signalverzögerungen zu minimieren. Zur Abtrennung der Leiterflächen 16 bzw. der Vias 18 werden jeweils die dünnen Verbindungsleitungen 20 bzw. 21 mittels eines Schneidelasers durchgetrennt.

Durch die Messung der Verzögerungs- bzw. Signallaufzeiten auf den Signalübertragungsleitungen eines Netzes zwischen den integrierten Schaltungen, d. h. den Speicherbausteinen 2, und das selektive Abtrennen der kapazitiven Laststrukturen lässt sich eine Abstimmung bzw. ein Abgleich der Verzögerungszeiten in einem Verzögerungszeitfenster kleiner als 20 ps erreichen. Diese Schritte können auch wiederholt ausgeführt werden.

Die in Figur 1B gezeigten kapazitiven Laststrukturen, d. h. die Leiterflächen 16 und/oder die Vias 18, lassen sich so ausführen, dass ihre Kapazität zum jeweiligen Chipgehäuse jeweils im Femto- oder Subfemtofaradbereich liegt.

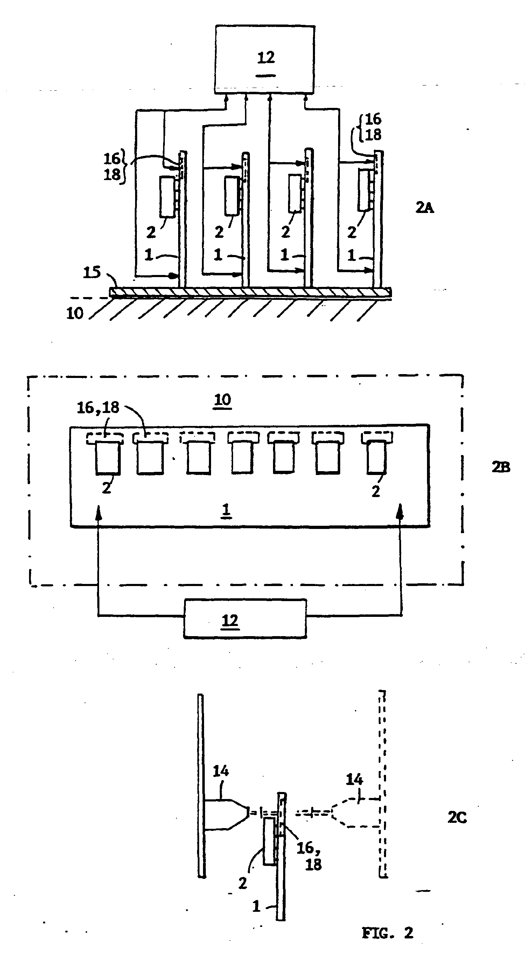

Die Figuren 2A, 2B und 2C zeigen schematisch jeweils eine zur Durchführung des erfindungsgemäßen Verfahrens eingerichtete Vorrichtung und zwar in den Figuren 2A und 2B im Aufriss und in Draufsicht bei der Messung der Verzögerungszeiten bzw. der Signallaufzeiten auf den Netzen, die einzelne integrierte Schaltungen, z. B. Speicherbausteine 2 auf einer gedruckten Leiterplatte 1 oder auf mehreren gedruckten Leiterplatten 1 miteinander verbinden und in Figur 2C beim Durchtrennen von kapazitiven Laststrukturen 16, 18.

Dabei können mehrere gedruckte Leiterplatten 1, wie Figur 2A zeigt, auf einem Motherboard 15 montiert sein, oder die Messung kann gemäß Figur 2B auf einer einzelnen Leiterplatte 1 ausgeführt werden. Die Messmittel 12 sind mit Messfühlern versehen, die einen kapazitätsarmen, d. h. rein ohmschen Kontakt mit den einzelnen Leiterbahnen eines interessierenden Leitungssystems bzw. Netzes herstellen, und zwar am Steckerkontakt der einzelnen Speichermodule auf Einzelmodulebene oder Motherboardebene.

Die Figuren 2A und 2B zeigen außerdem Haltemittel, z. B. einen Tisch 10, der zur Halterung wenigstens einer gedruckten Leiterplatte 1 eingerichtet ist.

Figur 2C zeigt die zur Durchführung des erfindungsgemäßen Verfahrens eingerichtete Vorrichtung bei der Ausführung des Trennschritts, bei dem mittels eines Schneidelasers 14 gezielt einzelne Verbindungsleitungen 20, 21 (Fig. 1B) auf der gedruckten Leiterplatte 1 entsprechend dem mit einer Anordnung gemäß den Figuren 2A, 2B ermittelten Messergebnis abgetrennt werden.

Figur 2C macht deutlich, dass das Abtrennen von Verbindungsleitungen von beiden Seiten der Leiterplatte vom Laser 14 ausgeführt werden kann.

Zu erwähnen ist, dass die in Figur 1B ersichtlichen Verbindungsleitungen 20, 21 der kapazitiven Laststrukturen mit den eigentlichen Leiterbahnen nicht mit Lötstopplack verdeckt sein dürfen, damit das erfindungsgemäß bevorzugte Laserschneiden möglich ist.

Durch das erfindungsgemäße Verfahren lassen sich kleinste Verzögerungszeitfenster unter 5 ps auf herkömmlichem FR-4 Material der gedruckten Leiterplatte erreichen. Es können nicht oder unterschiedlich abgestimmte Chips und Gehäuse, auch mit verschiedenen Prozesstechnologien hergestellte Chips und Gehäuse, verschiedene Materialien in den Einzelkomponenten auf einer gedruckten Leiterplatte mittels des erfindungsgemäßen Verfahrens abgeglichen werden.

Da die Feinabstimmung mit dem erfindungsgemäßen Verfahren nach der Bestückung der gedruckten Leiterplatte mit den Speicherbausteinen erfolgt, können Komponenten, die aus einem Spezifikationsrahmen fallen, nachträglich einer Reparatur unterzogen werden und müssen deshalb nicht ausgesondert werden. Dies ergibt eine Steigerung der Herstellungsausbeute bei vorhandenem kleinem Verzögerungszeitfenster.

Ferner lassen sich die Herstellungstoleranzen der Leiterplatten, die meist nicht beeinflussbar sind, und der Chipgehäuse, die nur schwer beeinflussbar sind, mit dem erfindungsgemäßen Verfahren ausgleichen.

Es ist zu bemerken, dass die in Figur 2 dargestellte Vorrichtung lediglich schematisch eine Prinzipanordnung zeigt und dass sich Details einer realisierbaren Anordnung davon unterscheiden können, sofern sie nicht von den Merkmalen der beiliegenden Ansprüche abweichen.

## Patentansprüche

1. Verfahren zur Anpassung/Abstimmung von Signallaufzeiten auf Leitungssystemen oder Netzen zwischen auf gedruckten Leiterplatten montierten integrierten Schaltungen, insbesondere schnellen Speicherbausteinen,
**gekennzeichnet durch**
folgende Schritte:
A) Vorsehen von Leiterplatten mit kapazitiven Laststrukturen an wenigstens einem Leiterbahnzug des Leitungssystems oder Netzes in der Nähe des oder der Gehäuse der integrierten Schaltung(en);
B) Messen relevanter Verzögerungs- bzw. Signallaufzeiten auf dem Netz oder dem Leitungssystem zwischen den integrierten Schaltungen;
C) selektives Abtrennen von bestimmten kapazitiven Laststrukturen von dem wenigstens einen Leiterbahnzug gemäß dem Messergebnis in Schritt B, um auftretende maximale Signalverzögerungen zu minimieren.

2. Verfahren nach Anspruch 1,
**dadurch gekennzeichnet ,**
**dass** die Schritte B und C wiederholt werden.

3. Verfahren nach Anspruch 1 oder 2,
**dadurch gekennzeichnet,**
**dass** die kapazitiven Laststrukturen in Schritt A jeweils eine Kapazität im Femto- oder Sub-Femtofaradbereich aufweisen.

4. Verfahren nach einem der vorangehenden Ansprüche,
**dadurch gekennzeichnet,**
**dass** der selektive Trennschritt C durch Laserschneiden ausgeführt wird.

5. Verwendung des Verfahrens nach einem der vorangehenden Ansprüche zur Signallaufzeitanpassung auf Leitungssystemen oder Netzen zwischen auf gedruckten Leiterplatten montierten schnellen DRAM-Speicherbausteinen.

6. Verwendung nach Anspruch 5 bei nicht oder unterschiedlich abgestimmten Chips und Gehäusen.

7. Verwendung nach Anspruch 5 oder 6 bei unterschiedlichen Materialien von DRAM-Bausteinen.

8. Verwendung nach einem der Ansprüche 5-7 zum Ausgleich von Herstellungstoleranzen von gedruckten Leiterplatten und/oder Chipgehäusen.

9. Vorrichtung zur Anpassung/Abstimmung von Signallaufzeiten auf Leitungssystemen oder Netzen zwischen auf gedruckten Leiterplatten montierten integrierten Schaltungen, insbesondere schnellen Speicherbausteinen,
**dadurch gekennzeichnet,**
**dass** die Vorrichtung in Kombination aufweist:
- Haltemittel (10) zur Halterung wenigstens einer mit der bzw. den integrierten Schaltung(en) (2) bestückten Leiterplatte (1), die mit kapazitiven Laststrukturen (16, 18) an wenigstens einem Leiterbahnzug (3-9) eines Leitungssystems oder Netzes in der Nähe des oder der Gehäuse der integrierten Schaltung(en) (2) versehen ist bzw. sind;
- Messmittel (12) zur Messung relevanter Verzögerungs- bzw. Signallaufzeiten auf den Netzen oder Leitungssystemen zwischen den integrierten Schaltungen auf der bzw. den Leiterplatte(n) (1), und
- Trennmittel (14) zur selektiven Abtrennung bestimmter kapazitiver Laststrukturen so, dass durch die Messmittel gemessene maximale Signalverzögerungen minimiert werden.

10. Vorrichtung nach Anspruch 9,
**dadurch gekennzeichnet,**
**dass** die kapazitiven Laststrukturen Flächen (16) und/oder Vias (18) aufweisen.

11. Vorrichtung nach Anspruch 9 oder 10,
**dadurch gekennzeichnet,**
**dass** die Trennmittel (14) einen Schneidelaser aufweisen.

12. Speicherbaugruppe mit einer gedruckten Leiterplatte und mindestens einem darauf montierten Speicherbaustein,
**dadurch gekennzeichnet,**
**dass** die gedruckte Leiterplatte (1) an wenigstens einer zu einem Signalübertragungsnetz oder -leitungssystem, das Signale zum/vom Speicherbaustein überträgt gehörenden Leiterbahn in der Nähe der Gehäuse-Footprintfläche des Speicherbausteins mit leicht abtrennbaren Leitungsstrukturen (16, 18), wie Flächen oder Vias versehen ist, die zur Leiterbahn und zu dem Gehäuse des montierten Speicherbausteins eine kapazitive Last bilden, wobei bestimmte der kapazitiven Laststrukturen an Leiterbahnen mit maximaler Signalverzögerung zur Minimierung gemessener maximaler Signallaufzeiten selektiv abtrennbar sind.

## Claims

1. Method for adapting/tuning signal transit times on line systems or networks between integrated circuits which are mounted on printed circuit boards, in particular high-speed memory modules, **characterized by** the following steps:
A) printed circuit boards with capacitive load structures are provided on at least one conductor track path of the line system or network in the vicinity of the housing or housings of the integrated circuit or circuits;
B) relevant delay or signal transit times on the network or the line system between the integrated circuits are measured;
C) specific capacitive load structures are selectively disconnected from the at least one conductor track path depending on the measurement result in step B, in order to minimize maximum signal delays which occur.

2. Method according to Claim 1, **characterized in that** the steps B and C are repeated.

3. Method according to Claim 1 or 2, **characterized in that** the capacitive load structures in step A each have a capacitance in the femtofarad range or subfemtofarad range.

4. Method according to one of the preceding claims, **characterized in that** the selective disconnection step C is carried out by means of laser cutting.

5. Use of the method according to one of the preceding claims for adapting signal transit times on line systems or networks between high-speed DRAM memory modules mounted on printed circuit boards.

6. Use according to Claim 5 with chips and housings which are not tuned or tuned differently.

7. Use according to Claim 5 or 6 with different materials of DRAM modules.

8. Use according to one of Claims 5-7 for compensating manufacturing tolerances of printed circuit boards and/or chip housings.

9. Device for adapting/tuning signal transit times on line systems or networks between integrated circuits which are mounted on printed circuit boards, in particular high-speed memory modules, **characterized in that** the device has, in combination:
- securing means (10) for securing at least one printed circuit board (1) which is equipped with the integrated circuit or circuits (2) and is provided with capacitive load structures (16, 18) on at least one conductor track path (3-9) of a line system or network in the vicinity of the housing or housings of the integrated circuit or circuits (2);
- measuring means (12) for measuring relevant delay or signal transit times on the networks or line systems between the integrated circuits on the printed circuit board or boards (1), and
- disconnection means (14) for selectively disconnecting specific capacitive load structures in such a way that maximum signal delay times measured by the measuring means are minimized.

10. Device according to Claim 9, **characterized in that** the capacitive load structures have surfaces (16) and/or vias (18).

11. Device according to Claim 9 or 10, **characterized in that** the disconnection means (14) have a cutting laser.

12. Memory module having a printed circuit board and at least one memory module mounted on it, **characterized in that** the printed circuit board (1) is provided with easily disconnectable line structures (16, 18), such as surfaces or vias, on at least one conductor track in the vicinity of the housing footprint area of the memory module, said conductor track being part of a signal transmission network or line system which transmits signals to and from the memory module and said disconnectable line structures (16, 18) forming a capacitive load with respect to the conductor track and to the housing of the mounted memory module, with certain of the capacitive load structures being selectively disconnectable at conductor tracks with a maximum signal delay in order to minimize known maximum signal transit times.

## Revendications

1. Procédé d'adaptation/accord de temps de propagation de signaux sur des systèmes de lignes ou des réseaux entre des circuits intégrés montés sur des plaquettes à circuit imprimé, notamment sur des modules de mémoire rapides,
**caractérisé par** des stades suivants :
A) on prévoit des plaquettes à circuit imprimé ayant des structures de charge capacitives sur au moins une voie de conductrice du système de ligne ou du réseau à proximité du ou des boîtiers du ou des circuits intégrés ;
B) on mesure des temps de propagation de retard ou de signal, qui sont pertinents sur le réseau ou sur le système de lignes entre les circuits intégrés ;
C) on sépare sélectivement des structures de charge capacitives déterminées de la au moins une voie conductrice conformément aux résultats de la mesure au stade B) pour minimiser des retards maximum de signal qui se produisent.

2. Procédé suivant la revendication 1,
**caractérisé**
**en ce que** l'on répète les stades B) et C).

3. Procédé suivant la revendication 1 ou 2,
**caractérisé**
**en ce que** les structures de charge capacitives au stade A) ont respectivement une capacité de l'ordre du femto-farad ou du sub-femto farad.

4. Procédé suivant l'une des revendications précédentes,
**caractérisé en ce que** l'on effectue le stade C) de séparation sélective par coupure laser.

5. Utilisation du procédé suivant l'une des revendications précédentes pour l'adaptation de la durée de propagation du signal sur des systèmes de lignes ou des réseaux entre des modules de mémoire DRAM rapides montés sur des plaquettes à circuit imprimé.

6. Utilisation suivant la revendication 5 pour des puces et des boîtiers qui ne sont pas accordés ou qui sont accordés différemment.

7. Utilisation suivant la revendication 5 ou 6 pour des matériaux différents de module DRAM.

8. Utilisation suivant l'une des revendications 5 à 7 pour compenser des tolérances de fabrication de plaquettes à circuit imprimé et/ou de boîtiers de puces.

9. Dispositif d'adaptation/accord de temps de propagation de signal sur des systèmes de lignes ou des réseaux entre des circuits intégrés montés sur des plaquettes à circuit imprimé, notamment des modules de mémoire rapides,
**caractérisé**
**en ce que** le dispositif a en combinaison
- des moyens (10) de maintien d'au moins l'une des plaquettes (1) à circuit imprimé équipées du ou des circuits (2) intégrés qui est ou qui sont munies de structures (16, 18) de charge capacitives sur au moins une voie (3 à 9) conductrice d'un système de lignes ou d'un réseau à proximité du ou des boîtiers des ou du circuit (2) intégré ;
- des moyens (12) de mesure de temps de retard ou de propagation du signal sur le réseau ou les systèmes de lignes entre les circuits intégrés sur la ou les plaquettes (1) à circuit intégré et ;
- des moyens (14) de séparation sélective de certaines structures de charge capacitives de façon à minimiser les retards de signal maximum mesurés par les moyens de mesure.

10. Dispositif suivant la revendication 9, **caractérisé en ce que** les structures de charge capacitives ont des surfaces (16) et/ou des vias (18).

11. Dispositif suivant la revendication 9 ou 10, **caractérisé en ce que** les moyens (14) de séparation ont un laser de coupe.

12. Module de mémoire ayant une plaquette à circuit imprimé et au moins un module de mémoire qui y est monté,
**caractérisé**
**en ce que** la plaquette (1) à circuit imprimé est munie, sur au moins une voie conductrice appartenant à un réseau de transmission de signal ou à un système de lignes de transmission de signal qui transmet des signaux au module de mémoire ou depuis le module de mémoire à proximité de la surface d'empreinte du boîtier du module de mémoire, de structures (16, 18) conductrices pouvant être séparées facilement, comme des surfaces ou des vias, qui forment une charge capacitive menant à la voie conductrice et au boîtier du module de mémoire monté, certaines des structures de charge capacitives pouvant être séparées sélectivement sur des voies conductrices ayant un retard maximum du signal, pour minimiser des temps de propagation maximum du signal qui ont été mesurés.
